Europäisches Patentamt

European Patent Office

Office européen des brevets

(11) Veröffentlichungsnummer: **0 591 814 A1**

# EUROPÄISCHE PATENTANMELDUNG

(21) Anmeldenummer: **93115595.6**

(22) Anmeldetag: **28.09.93**

(51) Int. Cl.5: **G02B 6/12**, H01S 3/06

(30) Priorität: **06.10.92 DE 4233500**

(43) Veröffentlichungstag der Anmeldung:
**13.04.94 Patentblatt 94/15**

(84) Benannte Vertragsstaaten:
**AT BE CH DE DK ES FR GB GR IT LI NL PT SE**

(71) Anmelder: **ANT Nachrichtentechnik GmbH**
**Gerberstrasse 33**
**D-71522 Backnang(DE)**

(72) Erfinder: **Hillmer, Hartmut, Dr. rer. nat.**
**Peter-Behrens-Strasse 12**
**D-64287 Darmstadt(DE)**

(54) Lichtwellenleiter zur kontinuierlichen Phasenverschiebung der DFB-Periode.

(57) 2.1. Bei bekannten Lösungen zur Phasenverschiebung auf DFB-Gitterfeldern werden zumeist mehr oder weniger abrupte Phasenverschiebungen realisiert. Mittels der erfindungsgemäßen Lösung sollen kontinuierliche Phasenverschiebungen zur Verbesserung wichtiger Kenngrößen von optoelektronischen Komponenten erzielt werden.

2.2. Erfindungsgemäß wird dies mittels eines im Bereich des DFB-Gitterfeldes der optoelektronischen Komponente eingebrachten Lichtwellenleiters erreicht, der auf einer Teillänge des Gitterfeldes gekrümmt ist. Die Form der Wellenleiterkrümmung, die Länge und die Amplitude des gekrümmten Wellenleiterbereiches bestimmen die Phasenverschiebung.

2.3. Der erfindungsgemäß ausgebildete Lichtwellenleiter ist in allen auf DFB-Gittern basierenden optoelektronischen Komponenten, wie z. B. Laser, Laserverstärker, Filter, Koppler und Schalter anwendbar.

EP 0 591 814 A1

Die erfindungsgemäße Losung ist in allen auf DFB-Gittern basierenden optoelektronischen Komponenten, wie beispielsweise Laser, Laser-Verstärker, Filter, Koppler und Schalter anwendbar. Sie ist unabhängig von der spezifischen Ausführung dieser Komponenten.

Es ist bekannt, daß in DFB-Gittern Phasenverschiebungen mittels holografischer Verfahren hergestellt und in das Gitter integriert werden. Bei diesen Verfahren werden jedoch nur mehr oder weniger abrupte Phasenverschiebungen erreicht.

Eine weitere Möglichkeit der Erzeugung von Phasenverschiebungen in DFB-Gittern besteht in der Reduktion der Wellenleiterbreite auf einer definierten Länge des Lichtwellenleiters. Mittels der dabei üblicherweise abrupt durchgeführten Aufweitung oder Reduktion der Wellenleiterbreite können ebenfalls nur abrupte Phasenverschiebungen erreicht werden.

In gewissem Rahmen ermöglicht auch die Elektronenstrahl-Lithographie EL die Realisierung von im Ortsraum verteilten Phasenverschiebungen. Allerdings ist bei diesem Verfahren die Differenz zwischen benachbarten Gitterperioden auf größere Werte begrenzt. Dadurch ermöglicht die EL lediglich die Herstellung von DFB-Gittern mit einer kleinen Anzahl verschiedener Sektionen innerhalb denen die Gitterperiode konstant ist, sich jedoch von Sektion zu Sektion unterscheidet. Siehe: M. Okai, T. Tsuchiya, K. Uomi, N. Chinone and T. Harada, "Corrugation-pitch modulated MQW-DFB lasers with narrow spectral linewidth ", IEEE J. Quant. Electron. 27, pp. 1767-72, 1991.
Ferner ist die EL ein kompliziertes Verfahren und die EL-Schreibzeit sehr teuer und damit ein wesentlicher Kostenfaktor. Darüber hinaus können keine quasikontinuierlichen Variationen der Gitterperiode mit dem Ort der Phasenverschiebung erreicht werden.

Abrupte Phasenverschiebungen in DFB-Gittern erzeugen je nach Kopplungsgrad verschieden starke Photonenzahl-Überhöhungen am Ort der Phasenverschiebung. Diese Photonenzahl-Überhöhungen beeinflussen einige Eigenschaften der optoelektronischen Komponenten im negativen Sinne.

Ziel der Erfindung ist es, negative Beeinflussungen der Kenngrößen optoelektronischer Komponenten, die durch abrupte Phasenverschiebungen in DFB-Gittern auftreten, zu vermeiden.

Die erfindungsgemäße Lösung beruht auf einer kontinuierlichen Verteilung der Phasenverschiebung von DFB-Gittern, durch welche die Photonenzahlüberhöhungen im Bereich der Phasenverschiebung beträchtlich reduziert werden.

Die kontinuierliche Verteilung der Phasenverschiebung wird erfindungsgemäß mittels eines im Bereich des DFB-Gitterfeldes einer optoelektronischen Komponente eingebrachten Lichtwellenleiters bewirkt, der auf einer Teillänge des Gitterfeldes gekrümmt ist. Die Erzeugung der Phasenverschiebung beruht darauf, daß im gekrümmten Teilbereich des Lichtwellenleiters der Wellenleiter nicht mehr senkrecht zu den Gitterstrichen des DFB-Gitterfeldes verläuft. Die Form der Wellenleiterkrümmung, die Länge und die Amplitude des gekrümmten Teilbereiches stellen somit eine feste Information dar, welche die gewünschte kontinuierliche Phasenverschiebung enthält.

Die effektive Gitterperiode, welche sich durch die lokale Llchtwellenleiterkrümmung definiert, ist eng mit dem Winkel $\vartheta(x)$ verknüpft. Dabei ist {90° - $\vartheta(x)$} der Winkel zwischen einer Gitterlinie und der Tangente an den Lichtwellenleiter an der betreffenden Stelle x. Die effektive Gitterperiode an jeder Stelle x des gekrümmten Teilbereiches ist aus der Beziehung

$$\Lambda\{\vartheta(x)\} = \Lambda_x/\cos\{\vartheta(x)\}$$

ableitbar. Die gesamte Phasenverschiebung, die in Form des gekrümmten Teilbereiches des Lichtwellenleiters als feste Information vorliegt, läßt sich durch Aufsummierung aller im gekrümmten Teilbereich des Lichtwellenleiters liegenden Differenzen $\{\Lambda[(x)] - \Lambda_x\}$ zwischen der effektiven Gitterperiode und der Grundperiode $\Lambda_x$ ermitteln.

Die erfindungsgemäße Lösung wird anhand eines Ausführungsbeispiels näher erläutert.

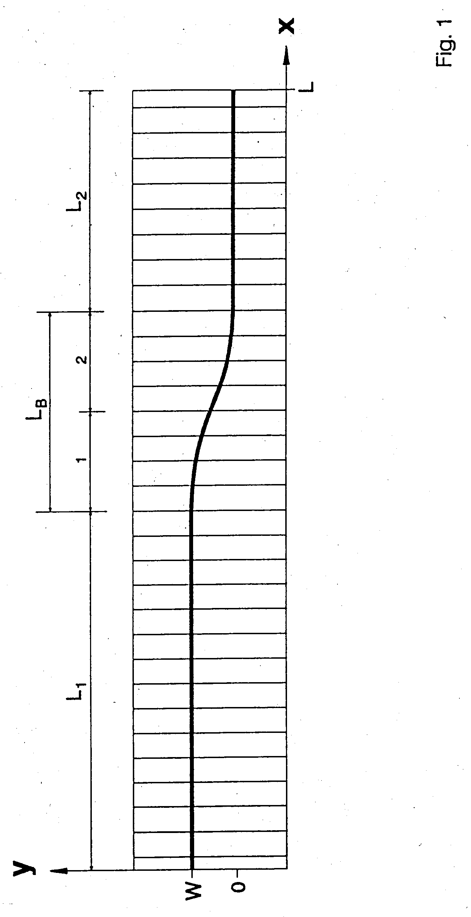

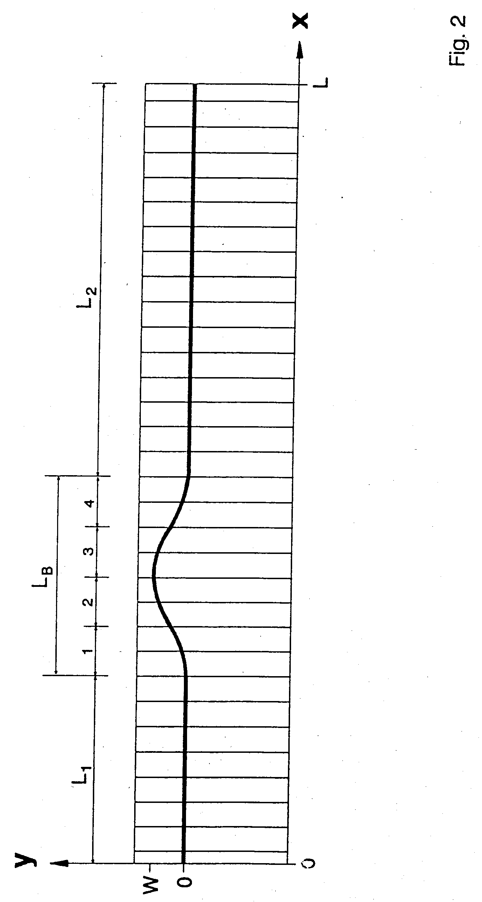

Figur 1 und Figur 2 zeigen anhand einer schematischen Darstellung zwei Beispiele lokal gekrümmter Wellenleiter auf DFB-Gitterfeldern mit konstanter Gitterperiode $\Lambda_x$. Die Gitterlinien verlaufen parallel der y-Achse und haben voneinander einen konstanten Abstand $\Lambda_x$. Die Gesamtlänge des Bauelements unterliegt, wie in Figur 1 und Figur 2 dargestellt, in Bezug auf den eingefügten Lichtwellenleiter einer Dreiteilung. Bei beiden Beispielen setzt sich die Gesamtlänge des Lichtwellenleiters aus drei Teillängen $L_1$, $L_B$, $L_2$ zusammen. Die Teillängen $L_1$ und $L_2$ bestehen aus geraden Lichtwellenleiterabschnitten, die senkrecht zu den Gitterlinien verlaufen. Die gekrümmte Teillänge $L_B$, die jeweils zwischen den Teillängen $L_1$ und $L_2$ angeordnet ist, setzt sich in Figur 1 aus zwei Teilbögen 1, 2 und in Figur 2 aus 4 Teilbögen 1 bis 4 zusammen. Die Phasenverschiebung kann auch am Rand des Bauelements liegen, d. h. $L_1$ = 0 oder $L_2$ = 0 oder $L_1$ = $L_2$ = 0 sind mögliche Grenzfälle. Die Teilbögen 1 bis 4 haben nicht notwendigerweise gleiche Länge. Das Beispiel in Fig. 1 erzeugt einen Seitenversatz in y-Richtung im Gegensatz zu dem in Fig. 2 angeführten Beispiel. In Fig. 2 ist bei identischem $L_B$ und gleichem Betrag der Gesamtphasenverschiebung der Wellenleiterverlust geringfügig größer.

Die mathematische Funktion, welche den gesamten Verlauf des Wellenleiters beschreibt, ist stetig und differenzierbar. Zur Erzeugung gängiger Phasenverschiebungswerte, z. B. $\pi/2$, sind nur sehr schwache Krümmungen erforderlich. Die Darstellung in Figur 1 übertreibt die Krümmung.

Die Gitterperiode kann im Bereich der Resonator-Teillänge, welche die Phasenverschiebung enthält, nach beliebigen mathematischen Funktionen variiert werden. Die mathematische Funktion definiert dabei die Form der Wellenleiterkrümmung. Es ist lediglich darauf zu achten, daß die Krümmungsradien nicht zu klein werden, was zu größeren Streuverlusten führt. Die erforderlichen Wellenleiterkrümmungen sind jedoch für eine Bauelementen-Länge von z. B. 600 $\mu$m für eine über 200 $\mu$m verteilte $\lambda/4$ Phasenverschiebung in der Größenordnung von >1 mm. Daher sind die Streuverluste vernachlässigbar.

Die im mathematischen Verlauf der Wellenleiterkrümmung enthaltenen Parameter können optimiert werden, um wichtige Kenngrößen des optoelektronischen Bauelements zu verbessern. Erzielt werden könnten beispielsweise:
- kleinere Linienbreiten
- reduziertes spektrales Lochbrennen und damit Verbesserung der longitudinalen Einmoden Stabilität
- bessere Hochfrequenzeigenschaften:
  * reduzierter Frequenz-Chirp
  * höhere Grenzfrequenzen unter hochfrequenter Modulation.

Durch die erfindungsgemäße Lösung kann eine theoretisch sehr kleine Differenz der Gitterperioden-Länge zwischen benachbarten Gitterstrichen erzielt werden ($<10^{-5}$ nm). Dies ist ein für die Elektronenstrahl-Lithographie unerreichbarer Wert. Mittels der erfindungsgemäßen Lösung kann eine äußerst präzise Einstellung des Betrages der Phasenverschiebung vorgenommen werden.

Eine äußerst praktikable Lösung wird in der Herstellung eines Lithografie-Maskensatzes zur Wellenleiterstrukturierung gesehen, welcher die Informationen über die Krümmung enthält. Das heißt, daß bei den einzelnen Prozeßschritten zur Wellenleiterstrukturierung und damit der Realisierung der Phasenverschiebung ein in sich konsistenter Lithografie-Maskensatz verwendet wird. Dabei kann, je nach Bedarf, auf ausgewählten Masken eine Vielzahl von gekrümmten Lichtwellenleiter-Mustern angeordnet sein. Einige Lithografieschritte lassen sich auch durch direktes Strukturieren des Photolacks auf dem Halbleiterwafer durch Elektronenstrahl-Lithografie mit optimierter Schreibstrategie ersetzen, um die Kantenrauhigkeit der Wellenleiterstruktur zu minimieren.

**Patentansprüche**

1. Lichtwellenleiter zur kontinuierlichen Phasenverschiebung der DFB-Gitterperiode für auf DFB-Gitterfeldern mit konstanter Gitterperiode basierende optoelektronische Komponenten, **dadurch gekennzeichnet,** daß in der optoelektronischen Komponente, im Bereich des DFB-Gitterfeldes, ein Lichtwellenleiter eingefügt ist, der in einem Teilbereich des Feldes so gekrümmt ist, daß er eine von der Form der Wellenleiterkrümmung, von der Länge und von der Amplitude des gekrümmten Teilbereiches abhängige kontinuierliche Phasenverschiebung als feste Information enthält, wobei sich die effektive Gitterperiode an jeder Stelle x des gekrümmten Teilbereiches aus der Beziehung $\Lambda\{\vartheta(x)\} = \Lambda_x/\cos\{\vartheta(x)\}$ ableitet, und daß sich die gesamte phasenverschiebung aus der Form der Wellenleiterkrümmung durch Aufsummierung aller im gekrümmten Teilbereich des Lichtwellenleiters liegenden Differenzen $\{\Lambda[\vartheta(x)] - \Lambda_x\}$ zwischen der effektiven Gitterperiode und der Grundperiode $\Lambda_x$ ergibt.

2. Lichtwellenleiter nach Anspruch 1, dadurch gekennzeichnet, daß zu seiner Realisierung ein in sich konsistenter Lithografie-Maskensatz verwendet wird, wobei je nach Bedarf auf ausgewählten Masken eine Vielzahl von Lichtwellenleiter-Mustern angeordnet ist.

Fig. 1

Fig. 2

EP 0 591 814 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| P,X | IEEE PHOTONICS TECHNOLOGY LETTERS<br>Bd. 5, Nr. 1, Januar 1993, NEW YORK<br>Seite 10-12<br>HILLMER ET AL.<br>* das ganze Dokument *<br>--- | 1 | G02B6/12<br>H01S3/06 |
| X | FR-A-2 591 818 (SONY CORP.)<br>* Seite 3, Zeile 24 - Seite 5, Zeile 8;<br>Abbildungen 1,2,4 *<br>--- | 1 | |
| X | US-A-5 052 015 (ACKERMAN ET AL.)<br>* Spalte 3, Zeile 28 - Spalte 4, Zeile 43;<br>Abbildungen 1-4 *<br>--- | 1 | |
| A | PATENT ABSTRACTS OF JAPAN<br>vol. 13, no. 51 (E-712)6. Februar 1989<br>& JP-A-63 244 694 ( SONY CORP. ) 12.<br>Oktober 1988<br>* Zusammenfassung *<br>--- | 1 | |
| A | PATENT ABSTRACTS OF JAPAN<br>vol. 12, no. 430 (E-682)14. November 1988<br>& JP-A-63 166 281 ( TOSHIBA CORP ) 9. Juli<br>1988<br>* Zusammenfassung *<br>--- | 1 | **RECHERCHIERTE SACHGEBIETE (Int. Cl.5)**<br><br>G02B<br>H01S |
| A | PATENT ABSTRACTS OF JAPAN<br>vol. 15, no. 434 (E-1129)6. November 1991<br>& JP-A-31 83 115 ( SEIKO EPSON CORP. ) 9.<br>August 1991<br>* Zusammenfassung *<br>--- | 2 | |
| A | PATENT ABSTRACTS OF JAPAN<br>vol. 12, no. 102 (P-684)5. April 1988<br>& JP-A-62 235 951 ( AGENCY OF IND. SCIENCE<br>& TECHNOLOGY ) 16. Oktober 1987<br>* Zusammenfassung *<br><br>----- | 2 | |

Der vorliegende Recherchenbericht wurde für alle Patentansprüche erstellt

| Recherchenort | Abschlußdatum der Recherche | Prüfer |
|---|---|---|
| BERLIN | 23 DEZEMBER 1993 | VON MOERS F. |

EPO FORM 1503 03.82 (P0403)